# FASCICULE DE BREVET EUROPEEN

(11) **EP 1 141 887 B1**
(45) Date de publication et mention de la délivrance du brevet: **05.02.2003**
(21) Numéro de dépôt: 99973502.0
(22) Date de dépôt: 29.11.1999
(51) Int. Cl.: G06K 19/077

(54) **PROCEDE DE FABRICATION DE CARTE A PUCE SANS CONTACT**
VERFAHREN ZUR HERSTELLUNG EINER KONTAKTLOSEN CHIPKARTE
METHOD FOR MAKING A CONTACTLESS CHIP CARD

(30) Priorité: 21.12.1998 FR 9816140
(43) Date de publication de la demande: 10.10.2001
(73) Titulaire: Gemplus, 13881 Gémenos Cedex (FR)
(72) Inventeur: ODDOU, Laurent, F-13600 La Ciotat (FR); AYALA, Stéphane, F-13010 Marseille (FR); ZAFRANY, Micha[l, F-13006 Marseille (FR)
(74) Mandataire: Scheer, Luc
(86) Numéro de dépôt international: FR9902942
(87) Numéro de publication internationale: WO00038111

(56) Documents cités:
- EP-A- 0 682 321
- EP-A- 0 737 935
- DE-A- 19 633 923
- US-A- 5 598 032

## Description

L'invention concerne les éléments portables tels que les cartes à puce sans contact comportant un corps de carte, un module électronique et, connectée audit module, une antenne.

Ces cartes sont destinées à diverses opérations telles que bancaires, téléphoniques, ou d'identification, télébillétique.

Ces opérations s'effectuent grâce à un couplage électromagnétique à distance, en mode lecture ou en mode lecture/écriture.

On connaît un procédé de réalisation de cartes à puce sans contact utilisant une technique de lamination à froid.

Ce procédé présente l'inconvénient lié au fait que l'ensemble électronique n'est pas complètement solidaire de l'une des feuilles extérieures de la carte. Par conséquent, il arrive que l'indexation de l'ensemble électronique soit décalée par rapport aux feuilles extérieures. Ce décalage peut entraîner la découpe et la destruction de l'ensemble électronique, au moment de la découpe des feuilles au format carte, lorsque celles-ci n'ont pas été préalablement découpées. De plus, la manipulation de trois éléments indépendants est nécessaire: deux feuilles extérieures et un ensemble électronique.

D'autre part, au moment de la dispense de la résine liquide, il se forme des bulles d'air autour de l'ensemble électronique. Ces bulles d'air engendrent la création de défauts à la surface de la carte. Ces défauts superficiels sont non seulement inesthétiques mais ils impliquent en outre des difficultés au moment de l'étape d'impression pour décorer et personnaliser la carte. Ces défauts superficiels ont en outre tendance à se propager et à grossir au cours du vieillissement de la carte, du fait des variations de températures que cette-dernière subit.

Le document US-A-5,598,032 décrit un procédé de fabrication d'une carte sans contact dans lequel une couche additionnelle est prévue. Une cavité est formée dans cette couche additionnelle pour constituer un logement pour un microcircuit. La connexion électrique entre le microcircuit et l'antenne est obtenue à l'aide de languettes. Il n'est pas prévu dans ce document d'isoler le microcircuit des spires de l'antenne.

Le document EP-A-0.737.935 décrit l'utilisation d'une couche anisotrope pour connecter un microcircuit aux bornes de l'antenne. Aucun pont isolant ni de matière de remplissage n'est prévu.

Le document EP-A-0682.321 qui reflète le préambule des revendications indépendantes ne décrit pas non plus de pont isolant ni de matière de remplissage.

Le document DE-A-196.33.923 décrit, en plus du montage d'un microcircuit sur des spires d'antenne, le montage de composants passifs à l'aide de ponts conducteurs présentant un côté isolant pour isoler le pont conducteur des spires de l'antenne.

Des procédés ne permettraient pas l'utilisation d'un module dans de bonnes conditions de fonctionnement, mais uniquement celle d'une puce. En effet, si on utilisait un module, celui-ci serait reporté de telle sorte que sa grille métallique, comportant des plages de contact, soit orientée vers les pistes de l'antenne. Une colle isolante permet de fixer le module sur les pistes de l'antenne tout en évitant l'apparition de courts-circuits entre cette antenne et la grille métallique du module. Des plages de contact de la grille métallique du module sont directement connectées aux bornes de connexion de l'antenne. Cependant, dans ce cas, il serait très difficile de maîtriser l'isolation d'une part entre les pistes de l'antenne et, d'autre part, entre l'antenne et la grille métallique du module.

Enfin, la colle isolante, utilisée pour fixer le module et l'isoler électriquement des spires d'antenne, ne se répartit pas toujours correctement entre les pistes de l'antenne, si bien qu'il peut se former des bulles d'air autour du module. Ces bulles d'air engendrent la création de défauts à la surface de la carte, qui sont inesthétiques et impliquent des difficultés lors de l'étape d'impression et de personnalisation de la carte.

Un but de l'invention consiste à fabriquer une carte à puce sans contact, comportant un module électronique connecté à une antenne, la réalisation de cette carte ne nécessitant la manipulation que de deux éléments indépendants, et permettant de pallier aux inconvénients liés aux procédés de l'art antérieur.

L'invention a plus particulièrement pour objet un procédé de fabrication d'un support à puce sans contact conforme à la revendication 1.

Grâce au procédé selon l'invention, il n'y a plus que deux éléments indépendants à manipuler, c'est à dire les deux feuilles extérieures. L'ensemble électronique étant solidaire d'une des feuilles extérieures, les problèmes d'indexation ne se posent plus. Le pont isolant assure une isolation électrique des pistes d'antenne et de la grille métallique du module. Il permet aussi de chasser l'air résiduel situé entre les pistes de l'antenne. La matière de remplissage comble l'espace entre le module et le pont isolant et permet de chasser l'air résiduel autour du module. L'air résiduel étant chassé, l'apparition de bulles d'air et de défauts de surface est évitée.

La matière de remplissage est par exemple une colle à base de cyanoacrylate.

Selon une autre caractéristique de l'invention, le pont isolant présente une forme sensiblement rectangulaire et possède deux encoches à deux emplacements déterminés pour permettre une mise à nu des bornes de connexion de l'antenne. Ce pont isolant est de préférence réalisé par sérigraphie d'une résine liquide, puis polymérisation sous rayons ultra-violets. Il présente de préférence une épaisseur comprise entre 15 et 60µm.

Selon une autre caractéristique de l'invention, la connexion électrique entre le module et l'antenne est réalisée par l'intermédiaire d'une colle électriquement conductrice qui est déposée sur les bornes de connexion de l'antenne.

Selon une autre caractéristique de l'invention, le microcircuit peut en outre être remplacé par une puce de circuit intégré.

Selon une autre caractéristique, le microcircuit est déposé dans un module électronique de telle sorte que les plages de contact métalliques soient disposées contre le pont isolant et la matière de remplissage.

Un autre objet de l'invention concerne en outre une carte à puce sans contact conforme à la revendication 10.

D'autres particularités et avantages de l'invention apparaîtront à la lecture de la description suivante donnée à titre d'exemple illustratif mais non limitatif et faite en référence aux figures annexées qui représentent :
- les figures 1A et 1B, respectivement une vue en coupe longitudinale et une vue de dessus d'une carte à puce sans contact au cours d'une première étape du procédé de fabrication selon l'invention,
- la figure 2, une vue en coupe longitudinale de la carte à puce sans contact des figures 1A et 1B à un autre stade de sa fabrication,
- les figures 3A à 3D, des vues de dessus schématisant les étapes de réalisation d'un pont isolant au dessus d'une antenne, en vue de préparer le report d'un module,
- la figure 4, une vue en coupe longitudinale de la carte à puce sans contact des figures 1A à 3, à un stade final de son procédé de fabrication,
- la figure 5, une vue en coupe longitudinale d'une autre carte à puce, selon une variante de réalisation, à un stade final de son procédé de fabrication.

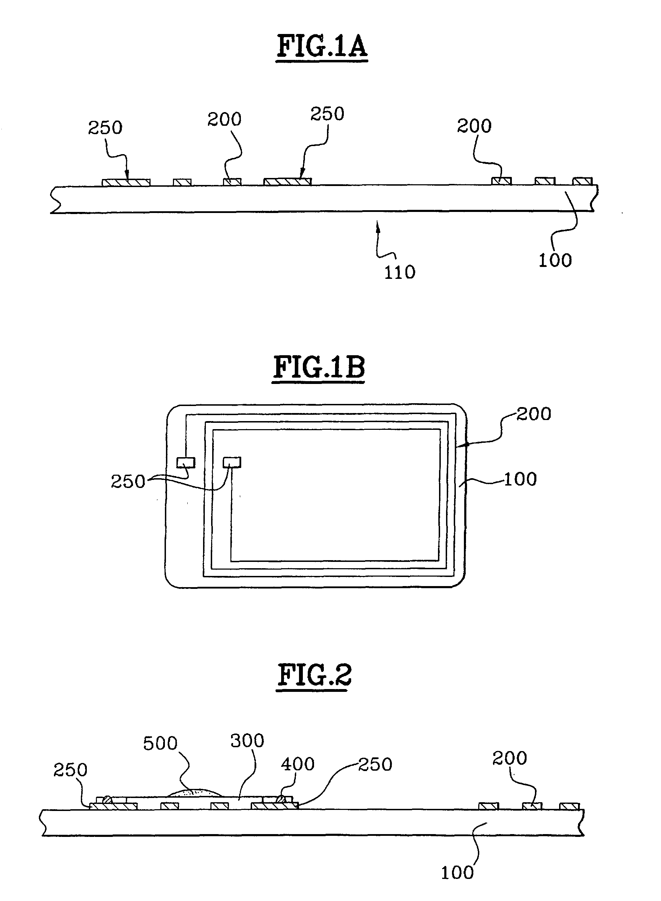

Une première étape du procédé de fabrication selon l'invention consiste à réaliser une antenne 200 sur un substrat 100 (figures 1A et 1B). Le substrat 100 est en matière plastique, par exemple en polychlorure de vinyle (PVC). Il peut être tout support et se présenter notamment sous la forme d'un ruban, ou d'une grande feuille. Dans ce cas, il peut être découpé au format carte, à un stade quelconque du procédé de fabrication. Dans une variante, il peut également être préalablement découpé au format carte. Dans l'exemple illustré sur les figures 1A et 1B, ce substrat est déjà découpé au format carte, avant la réalisation de l'antenne, et se présente sous la forme d'une feuille. Son épaisseur est par exemple comprise entre 100 et 200µm. La face 110 opposée à celle qui supporte l'antenne 200 est destinée à former une surface extérieure du corps de carte.

L'antenne 200 est par exemple réalisée par sérigraphie d'encre conductrice, telle qu'une encre à argent par exemple. Cette encre est ensuite séchée à une température de l'ordre de 60°C pendant une durée comprise entre environ 2 et 15 minutes. Dans une variante de réalisation, l'antenne peut également être réalisée selon d'autres techniques connues telles que l'incrustation d'un fil conducteur ou la gravure d'un film de cuivre ou d'aluminium par exemple. Elle se présente sous la forme d'une spirale et comprend au moins deux spires. Typiquement, les pistes conductrices de l'antenne présentent une largeur comprise entre 0,15 et 3mm, et sont espacées les unes des autres d'une valeur comprise entre 0,15 et 2mm.

L'épaisseur de l'antenne est par exemple comprise entre 10 et 40µm. L'antenne 200 comporte d'autre part, à ses extrémités, deux bornes de connexions 250 destinées à permettre la liaison électrique avec un module électronique. L'espacement entre ces bornes de connexion 250 est de préférence compris entre 2 et 15 mm. De plus, l'antenne est réalisée sous la forme d'une spirale de sorte que les spires d'antenne passent entre les bornes de connexion 250.

L'étape suivante du procédé de fabrication de la carte à puce sans contact selon l'invention, illustrée sur la figure 2, consiste à réaliser un pont isolant 300 recouvrant en partie les spires d'antenne 200 à l'exception des bornes de connexion 250. Le pont isolant 300 est réalisé dans une matière diélectrique se présentant par exemple sous la forme d'une résine liquide, telle que par exemple la résine commercialisée sous la référence CB018 par la société Dupont de Nemours. Ce pont isolant 300 assure une isolation électrique entre les pistes de l'antenne 200 passant entre les bornes de connexion 250 de cette antenne. De plus, il permet d'éviter la création de courts-circuits entre l'antenne et le module électronique, lors du report de ce-dernier. Le rôle et les avantages de ce pont isolant sont expliqués plus en détails dans la suite de la description se rapportant à l'étape du report du module électronique.

Ce pont isolant 300 est réalisé sur une épaisseur suffisante pour recouvrir correctement les spires d'antenne. Ainsi, son épaisseur globale est de préférence comprise entre 15 et 60µm afin de recouvrir les spires d'antenne sur une épaisseur comprise entre 5 et 20µm.

Le pont isolant 300 est par exemple réalisé par sérigraphie de la résine liquide. Cette sérigraphie permet d'assurer à la fois un dépôt avec une géométrie bien définie et le remplissage des espaces situés entre les pistes de l'antenne, l'air de ces espaces étant alors chassé de ces espaces par la résine. A la suite de cette sérigraphie, une polymérisation sous rayons ultra-violets permet une solidification du pont isolant. Dans une variante de réalisation, le pont isolant peut également être obtenu par pulvérisation de la résine liquide.

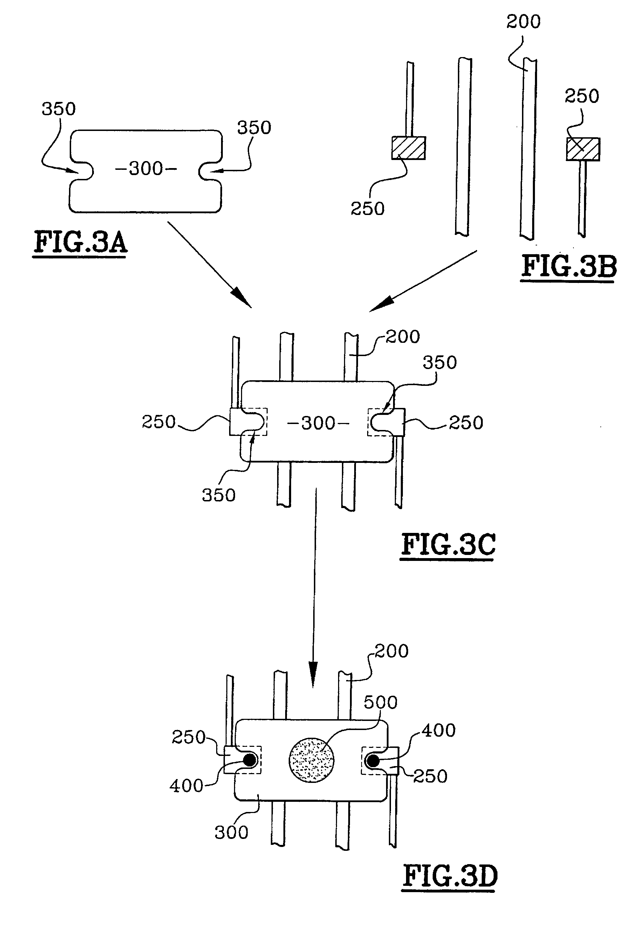

Les figures 3A à 3D schématisent une géométrie préférée de ce pont isolant 300 ainsi que sa disposition sur les spires d'antenne 200. Le pont isolant 300 est réalisé selon une forme sensiblement rectangulaire et comporte deux encoches 350. Ces deux encoches 350 sont disposées sur les côtés latéraux du pont isolant, dans une zone prévue pour être superposée aux bornes de connexion 250 de l'antenne 200.

Ainsi, le pont isolant 300 permet de recouvrir une zone des spires d'antenne 200, située entre les bornes de connexion 250, tout en laissant au moins une partie desdites bornes de connexion 250 à nu grâce aux encoches 350.

Une étape suivante du procédé consiste ensuite à déposer une matière conductrice 400 sur les bornes de connexion 250 de l'antenne 200 en vue de la réalisation d'une connexion électrique entre un module électronique et l'antenne. Cette matière conductrice 400 est par exemple constituée d'une colle contenant des particules conductrices d'argent.

D'autre part une goutte de matière de remplissage 500, d'environ 1 à 3mm de diamètre par exemple, est dispensée au centre du pont isolant 300. Cette matière peut par exemple être constituée d'une colle isolante à base de cyanoacrylate par exemple. La matière de remplissage doit être apte à s'étaler et à remplir l'espace entre le pont isolant 300 et le module quand ce dernier sera reporté à l'étape ci-dessous. Le remplissage de cet espace évite l'air résiduel à l'origine de l'apparition de bulles d'air qui entraînent des défauts de surface. Dans une variante de réalisation, cette matière de remplissage 500 peut être déposée sous forme d'un trajet rectiligne. La goutte de remplissage est déposée de préférence après la matière conductrice 400.

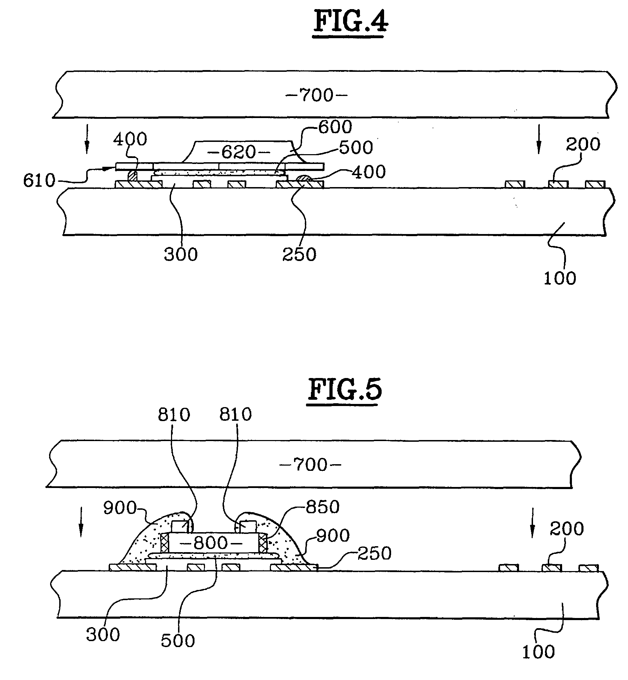

Un module électronique 600 est ensuite reporté au-dessus du pont isolant 300 recouvrant les spires d'antenne 200 (voir figure 4). Le module 600 utilisé est un module classique, qui comprend une puce de circuit intégré dont les plots de contact sont reliés, notamment par l'intermédiaire de fils conducteurs, aux plages de contact d'une grille métallique 610 en cuivre nickelé et doré. La puce et les fils conducteurs sont par ailleurs protégés par une résine d'encapsulation 620. Le module 600 est reporté de telle sorte que sa grille métallique 610, comportant ses plages de contact, soit appliquée en regard du pont isolant 300 et de la matière de remplissage 500. Les dimensions du module 600 à reporter sont variables, la longueur est par exemple comprise entre 3 et 20 mm et la largeur est également par exemple comprise entre 3 et 20mm. Il comporte aux moins 2 plages de contacts séparées disposées dans l'exemple aux extrémités opposées du module en regard des bornes de connexion 250 de l'antenne. Les plages de contact peuvent éventuellement reposer sur un film support de manière connue en soi.

Le module 600 est reporté par application d'une pression à son emplacement prédéfini. Sous l'effet de la pression appliquée, la matière de remplissage 500, à base de cyanoacrylate par exemple, flue et s'étale sous le module 600. En s'étalant, elle chasse ainsi l'air résiduel qui pourrait se trouver dans l'espace situé entre le pont isolant et le module et entraîner l'apparition de défauts de surface. Cette matière isolante de remplissage permet également d'assurer une fixation du module par collage mais cette fonction n'est pas essentielle ; son rôle principal consiste en effet à éviter tout vide sous le module, c'est à dire éviter toute présence d'air résiduel.

La majeure partie de la tenue mécanique du module sur l'antenne est assurée par le matériau de connexion 400. Dans l'exemple ce matériau de connexion 400 est constitué par une colle conductrice. L'étalement de cette matière conductrice 400 est contrôlé et guidé par la géométrie spécifique du pont isolant et notamment par les encoches 350. Ces encoches évitent en effet que la matière conductrice s'étale à la surface du pont isolant 300 et entraîne l'apparition de courts-circuits entre les plages de contact du module, lors de son report. La colle conductrice est ensuite polymérisée pendant par exemple environ 8 heures à une température d'environ 60°C. Cette polymérisation permet de souder l'ensemble et d'établir une connexion électrique de bonne qualité. Dans une variante il est en outre possible d'envisager de réaliser cette connexion électrique entre le module et l'antenne au moyen d'une soudure étain-plomb par exemple.

Dans une variante de réalisation, le module peut en outre être remplacé par une puce de circuit intégré. Cette variante est illustrée sur la figure 5. Dans ce cas, la puce 800 est reportée de telle sorte que sa face arrière non active soit appliquée contre le pont isolant 300 et la matière de remplissage 500. Un dépôt de résine conductrice 900 permet ensuite de réaliser la connexion électrique entre les plots de contact 810 de la puce 800 et les bornes de connexion 250 de l'antenne 200.

L'ensemble électronique, constitué par le module 600 (ou la puce 800) connecté à l'antenne 200, est alors entièrement réalisé et directement fixé sur la feuille support 100. Il est donc solidaire de la feuille support 100.

La dernière étape du procédé selon l'invention consiste ensuite à recouvrir l'ensemble électronique d'une deuxième feuille plastique 700 et à effectuer une lamination à froid. Lors de cette lamination à froid, une résine liquide, de type polyuréthanne par exemple, est délivrée pour permettre une soudure des deux feuilles plastiques 100 et 700 de constitution du corps de carte. L'air résiduel ayant été chassé autour de l'ensemble électronique, du fait du remplissage des espaces libres, des bulles d'air ne peuvent plus se former à ce stade de la fabrication.

Grâce au procédé selon l'invention, le nombre d'éléments indépendants est réduit à deux. Ces éléments indépendants sont constitués par la première feuille 100 support de l'ensemble électronique et par la deuxième feuille 700.

Le pont isolant 300 assure une isolation électrique entre les pistes de l'antenne 200 passant entre les bornes de connexion 250 de cette antenne ainsi qu'une isolation de la grille métallique du module 600. Sans la présence de ce pont isolant, les plages de contact métalliques du module seraient en contact direct avec les pistes de l'antenne et créeraient alors des courts-circuits néfastes pour le fonctionnement normal de l'ensemble électronique. Le pont isolant permet également de chasser l'air résiduel entre les pistes d'antenne et évite ainsi la formation de bulles d'air et de défauts de surface.

## Revendications

1. Procédé de fabrication d'un support à puce sans contact comprenant un ensemble électronique comportant une antenne (200) et un microcircuit (600) connecté à l'antenne, ledit ensemble électronique étant noyé dans un corps du support constitué de feuilles laminées, ledit procédé consistant à :
- réaliser l'antenne (200) sur une première feuille support (100), ladite antenne formant une spirale aux extrémités de laquelle sont prévues des bornes de connexion (250), **caractérisé en ce qu'**il comporte les étapes suivantes :
- réaliser un pont isolant (300) recouvrant en partie les spires d'antenne (200) à l'exception d'au moins une partie des bornes de connexion (250),
- déposer une goutte de matière de remplissage (500) sur le pont isolant, ladite matière de remplissage chassant l'air résiduel entre ledit pont isolant (300) et ledit microcircuit (600),
- reporter le microcircuit (600) contre le pont isolant (300) et la matière de remplissage (500), et établir une connexion électrique du microcircuit aux bornes de connexion (250) de l'antenne (200),
- reporter une deuxième feuille (700) contre l'ensemble électronique précédemment formé et effectuer une lamination desdites première et deuxième feuilles.

2. Procédé selon la revendication 1, **caractérisé en ce que** la matière de remplissage (500) est une colle à base de cyanoacrylate.

3. Procédé selon l'une quelconque des revendications précédentes, **caractérisé en ce que** le pont isolant (300) présente une forme sensiblement rectangulaire et possède deux encoches (350) à deux emplacements déterminés pour permettre une mise à nu des bornes de connexions (250) de l'antenne (200).

4. Procédé selon l'une quelconque des revendications précédentes, **caractérisé en ce que** le pont isolant (300) est réalisé par sérigraphie d'une résine liquide, puis polymérisation sous rayons ultra-violets.

5. Procédé selon l'une quelconque des revendications précédentes, **caractérisé en ce que** le pont isolant (300) présente une épaisseur comprise entre 15 et 60µm.

6. Procédé selon l'une quelconque des revendications précédentes, **caractérisé en ce que** la connexion électrique entre le microcircuit (600) et l'antenne (200) est réalisée par l'intermédiaire d'une colle électriquement conductrice qui est déposée sur les bornes de connexion (250) de l'antenne (200).

7. Procédé selon l'une quelconque des revendications précédentes, **caractérisé en ce que** l'antenne (200) présente une épaisseur comprise entre 10 et 40µm.

8. Procédé selon l'une quelconque des revendications précédentes, **caractérisé en ce que** le microcircuit (600) est remplacé par une puce de circuit intégré.

9. Procédé selon l'une quelconque des revendications précédentes, **caractérisé en ce que** le microcircuit est disposé dans un module électronique de telle sorte que les plages de contact métalliques soient disposées contre le pont isolant et la matière de remplissage.

10. Carte à puce sans contact, comportant un ensemble électronique constitué par un microcircuit (600) et, connecté audit microcircuit, une antenne (200), ledit ensemble électronique étant noyé dans le corps de la carte et fixé sur une première feuille support (100), l'antenne (200) étant réalisée sur ladite première feuille support (100), et le microcircuit (600) étant reporté de telle sorte que ses plages de contact métalliques (610) soient disposées face aux spires d'antenne ; **caractérisé en ce qu'**un pont isolant (300), recouvert d'une matière de remplissage (500), est disposé entre le microcircuit (600) et les spires de l'antenne (200), ledit pont isolant (300) présentant une géométrie telle qu'il ne recouvre pas les bornes de connexion (250) de l'antenne afin de permettre l'établissement d'une connexion électrique avec le microcircuit (600), ladite matière de remplissage chassant l'air résiduel entre ledit pont isolant (300) et ledit microcircuit (600).

## Patentansprüche

1. Herstellungsverfahren eines kontaktlosen Chipträgers mit einer Elektronikeinheit, die eine Antenne (200) und eine an die Antenne angeschlossene Mikroschaltung (600) aufweist, wobei die besagte Elektronikbaugruppe in einem Körper des Trägers eingebettet ist, der aus gewalzten Folien besteht, wobei das besagte Verfahren darin besteht:
- die Antenne (200) auf einer ersten Trägerfolie (100) herzustellen, wobei die besagte Antenne eine Spirale bildet, an deren Enden Anschlussklemmen (250) vorgesehen sind,
**dadurch gekennzeichnet, dass** es die folgenden Etappen umfasst:
- Herstellung einer isolierenden Brücke (300), die teilweise die Windungen der Antenne (200) abdeckt, mit Ausnahme von mindestens einem Teil der Anschlussklemmen (250),
- Anbringen eines Tropfens Füllstoffs (500) auf der isolierenden Brücke, wobei der besagte Füllstoff die Restluft zwischen der besagten isolierenden Brücke (300) und der besagten Mikroschaltung (600) vertreibt,
- Aufsetzen der Mikroschaltung (600) auf die isolierende Brücke (300) und den Füllstoff (500), und Herstellung eines elektrischen Anschlusses der Mikroschaltung an den Anschlussklemmen (250) der Antenne (200),
- Aufsetzen einer zweiten Folie (700) auf die zuvor gebildete Elektronikeinheit und Walzen der besagten ersten und zweiten Folie.

2. Verfahren nach Anspruch 1, **dadurch gekennzeichnet, dass** der Füllstoff (500) ein Kleber auf Cyanacrylat-Basis ist.

3. Verfahren nach einem der vorherigen Ansprüche, **dadurch gekennzeichnet, dass** die isolierende Brücke (300) eine etwa rechteckige Form aufweist und an zwei bestimmten Stellen zwei Kerben (350) besitzt, um ein Aufdecken der Anschlussklemmen (250) der Antenne (200) zu ermöglichen.

4. Verfahren nach einem der vorherigen Ansprüche, **dadurch gekennzeichnet, dass** die isolierende Brücke (300) per Siebdruck eines flüssigen Harzes, gefolgt von einer Polymerisierung unter Ultraviolettstrahlen hergestellt wird.

5. Verfahren nach einem der vorherigen Ansprüche, **dadurch gekennzeichnet, dass** die isolierende Brücke (300) eine Dicke zwischen 15 und 60 µm aufweist.

6. Verfahren nach einem der vorherigen Ansprüche, **dadurch gekennzeichnet, dass** der elektrische Anschluss zwischen der Mikroschaltung (600) und der Antenne (200) über einen elektrisch leitenden Kleber hergestellt wird, der auf die Anschlussklemmen (250) der Antenne (200) aufgetragen wird.

7. Verfahren nach einem der vorherigen Ansprüche, **dadurch gekennzeichnet, dass** die Antenne (200) eine Dicke zwischen 10 und 40 µm aufweist.

8. Verfahren nach einem der vorherigen Ansprüche, **dadurch gekennzeichnet, dass** die Mikroschaltung (600) durch einen IC-Chip ersetzt wird.

9. Verfahren nach einem der vorherigen Ansprüche, **dadurch gekennzeichnet, dass** die Mikroschaltung in einem Elektronikmodul angeordnet ist, so dass die metallischen Kontaktflächen gegen die isolierende Brücke und den Füllstoff angeordnet sind.

10. Kontaktlose Chipkarte mit einer Elektronikeinheit bestehend aus einer Mikroschaltung (600) und, angeschlossen an der besagten Mikroschaltung, einer Antenne (200), wobei die besagte Elektronikeinheit im Körper der Karte eingebettet und auf einer ersten Trägerfolie (100) befestigt ist, wobei die Antenne (200) auf der besagten ersten Trägerfolie (100) hergestellt ist, und wobei die Mikroschaltung (600) so aufgesetzt ist, dass ihre metallischen Kontaktflächen (610) gegenüber den Antennenwindungen angeordnet sind, **dadurch gekennzeichnet, dass** eine isolierende, mit einem Füllstoff (500) beschichtete Brücke (300) zwischen der Mikroschaltung (600) und den Windungen der Antenne (200) angeordnet ist, wobei die isolierende Brücke (300) eine derartige Geometrie aufweist, dass sie die Anschlussklemmen (250) der Antenne nicht abdeckt, um die Herstellung eines elektrischen Anschlusses an die Mikroschaltung (600) zu ermöglichen, wobei der besagte Füllstoff die Restluft zwischen der besagten isolierenden Brücke (300) und der besagten Mikroschaltung (600) vertreibt.

## Claims

1. A method for manufacturing a contactless chip support comprising an electronic assembly having an antenna (200) and a microcircuit (600) connected to the antenna, the said electronic assembly being embedded in a body of the support consisting of laminated sheets, the said method consisting in:
- producing the antenna (200) on a first support sheet (100), the said antenna forming a spiral at the ends of which connection terminals (250) are provided,
**characterised in that** it includes the following steps:
- producing an insulating bridge (300) partly covering the antenna turns (200) with the exception of at least part of the connection terminals (250),
- depositing a drop of filling material (500) on the insulating bridge, the said filling material driving out the residual air between the said insulating bridge (300) and the said microcircuit (600),
- attaching the microcircuit (600) against the insulating bridge (300) and the filling material (500), and establishing an electrical connection of the microcircuit at the connection terminals (250) of the antenna (200),
- attaching a second sheet (700) against the previously formed electronic assembly and effecting a lamination of the said first and second sheets.

2. A method according to Claim 1, **characterised in that** the filling material (500) is a glue based on cyanoacrylate.

3. A method according to any one of the preceding claims, **characterised in that** the insulating bridge (300) has a substantially rectangular shape and has two notches (350) at two locations determined so as to allow a baring of the connection terminals (250) of the antenna (200).

4. A method according to any one of the preceding claims, **characterised in that** the insulating bridge (300) is produced by screen printing in a liquid resin, and then polymerisation under ultraviolet radiation.

5. A method according to any one of the preceding claims, **characterised in that** the insulating bridge (300) has a thickness of between 15 and 60 µm.

6. A method according to any one of the preceding claims, **characterised in that** the electrical connection between the microcircuit (600) and the antenna (200) is produced by means of an electrically conductive glue which is deposited on the connection terminals (250) of the antenna (200).

7. A method according to any one of the preceding claims, **characterised in that** the antenna (200) has a thickness of between 10 and 40 µm.

8. A method according to any one of the preceding claims, **characterised in that** the microcircuit (600) is replaced with an integrated-circuit chip.

9. A method according to any one of the preceding claims, **characterised in that** the microcircuit is disposed in an electronic module so that the metallic contact areas are disposed against the insulating bridge and the filling material.

10. A contactless chip card having an electronic assembly consisting of a microcircuit (600) and, connected to the said microcircuit, an antenna (200), the said electronic assembly being embedded in the body of the card and fixed to a first support sheet (100), the antenna (200) being produced on the said first support sheet (100), and the microcircuit (600) being attached so that its metallic contact areas (610) are disposed facing the antenna turns; **characterised in that** an insulating bridge (300), covered with a filling material (500), is disposed between the microcircuit (600) and the turns of the antenna (200), the said insulating bridge (300) having a geometry such that it does not cover the connection terminals (250) of the antenna so as to allow the establishment of an electrical connection with the microcircuit (600), the said filling material driving out the residual air between the said insulating bridge (300) and the said microcircuit (300).
